# EUROPEAN PATENT APPLICATION

(11) **EP 2 914 076 A2**
(43) Date of publication of application: **02.09.2015**
(21) Application number: 15156891.2
(22) Date of filing: 27.02.2015
(51) Int. Cl.: H05K 7/20

(54) **Power converter and motor vehicle**

(30) Priority: 28.02.2014 JP 2014039458
(71) Applicant: Kabushiki Kaisha Yaskawa Denki, Kitakyushu-shi, Fukuoka 806-0004 (JP)
(72) Inventor: Nagao, Toshio, Kitakyushu-shi, Fukuoka 806-0004 (JP); Ikeda, Fumiaki, Kitakyushu-shi, Fukuoka 806-0004 (JP)
(74) Representative: Viering, Jentschura & Partner Patent- und Rechtsanwälte

(57) **Abstract**

A power converter includes a DC-DC converter circuit unit configured to step up or step down a voltage of direct current power supplied from a power supply, an inverter circuit unit configured to convert direct current power supplied from the power supply to alternating current power, and a first flow path portion and a second flow path portion through which a cooling medium flows. The first flow path portion is disposed between the DC-DC converter circuit unit and the inverter circuit unit. The second flow path portion is disposed at an opposite side of the inverter circuit unit from a side at which the first flow path portion is disposed.

## Description

### BACKGROUND OF THE INVENTION

### Field of the Invention

An embodiment disclosed herein relates to a power converter and a motor vehicle.

### Description of the Related Art

Conventionally, there is known a power converter mounted to an electric vehicle, a hybrid motor vehicle or the like (see, e.g., Japanese Patent No. 3031669). An electric vehicle or the like is equipped with, e.g., an AC load such as a traction motor or the like and a DC load such as a headlight or the like.

For that reason, the power converter includes a DC-DC converter circuit unit for stepping up or stepping down a DC voltage supplied from, e.g., a battery, and supplying DC power to a DC load, and an inverter circuit unit for converting DC power to AC power and supplying the AC power to an AC load.

The inverter circuit unit and the DC-DC converter circuit unit generate heat during operation thereof. Thus, in the power converter, the respective circuit units are disposed so as to make contact with a case. The respective circuit units are cooled by circulating a cooling medium through a bottom plate portion of the case.

In the conventional power converter, there is a room for further improvement in that the inverter circuit unit and the DC-DC converter circuit unit need to be cooled efficiently and effectively.

### SUMMARY OF THE INVENTION

In view of the aforementioned circumstances, an embodiment disclosed herein provides a power converter and a motor vehicle which are capable of efficiently and effectively cooling an inverter circuit unit and a DC-DC converter circuit unit.

In accordance with an embodiment, there is provided a power converter, including: a DC-DC converter circuit unit configured to step up or step down a voltage of direct current power supplied from a power supply; an inverter circuit unit configured to convert direct current power supplied from the power supply to alternating current power; and a first flow path portion and a second flow path portion through which a cooling medium flows, wherein the first flow path portion is disposed between the DC-DC converter circuit unit and the inverter circuit unit, and wherein the second flow path portion is disposed at an opposite side of the inverter circuit unit from a side at which the first flow path portion is disposed.

In accordance with one aspect of the embodiment disclosed herein, it is possible to efficiently and effectively cool the inverter circuit unit and the DC-DC converter circuit unit.

### BRIEF DESCRIPTION OF THE DRAWINGS

Fig. 1 is a view showing a configuration example of a power converter and a motor vehicle according to an embodiment.
Fig. 2 is a block diagram showing the configuration of the power converter.
Fig. 3A is a perspective view of the power converter.
Fig. 3B is a rear perspective view of the power converter shown in Fig. 3A.
Fig. 4 is an exploded perspective view of the power converter shown in Fig. 3A.
Fig. 5 is a sectional view taken along line V-V in Fig. 3A.
Fig. 6 is a bottom view of the power converter with a first cover removed.
Fig. 7 is a bottom view of the power converter with a first accommodation part removed from a second accommodation part.
Fig. 8A is a front view showing one example of a state in which the power converter is attached to a specified target attachment position of a motor vehicle.
Fig. 8B is a front view showing a modified example of the attachment of the power converter to the motor vehicle.
Fig. 9 is a view explaining the connection relationship between a cooling water inlet portion, a first cooling water outlet portion and a second cooling water outlet portion in the first accommodation part.
Fig. 10 is an exploded perspective view showing a power converter according to a modified example.

### DESCRIPTION OF THE EMBODIMENTS

An embodiment of a power converter and a motor vehicle disclosed herein will now be described in detail with reference to the accompanying drawings which form a part hereof. The present disclosure is not limited to the embodiment to be described below.

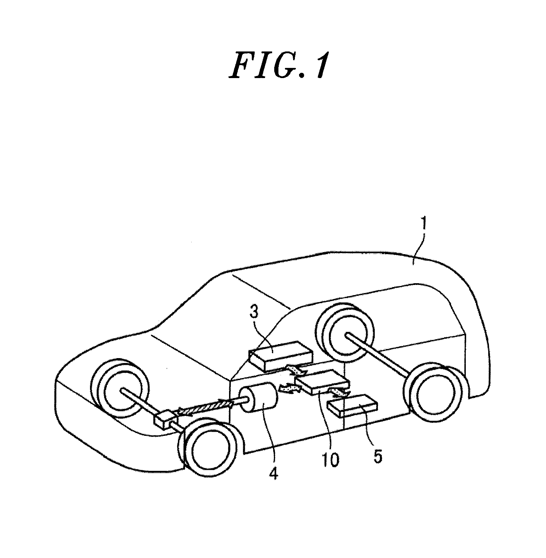

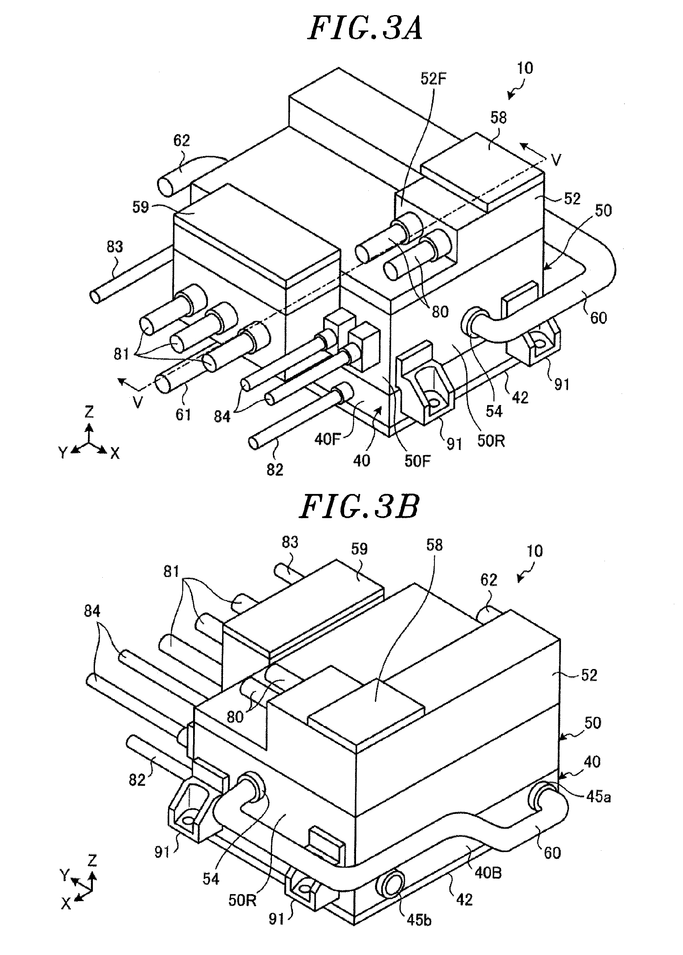

Fig. 1 is a view showing a configuration example of a power converter and a motor vehicle according to an embodiment. Fig. 1, Fig. 3A and the subsequent figures are schematic diagrams.

As shown in Fig. 1, a motor vehicle 1 includes a battery 3, an AC (alternating current) load 4, a DC (direct current) load 5 and a power converter 10. Specifically, the motor vehicle 1 such as an electric vehicle, a hybrid motor vehicle or the like includes an electric motor (the AC load 4) (a traction motor to be described later) as a power source of a drive system.

The battery 3 is a so-called a secondary battery which outputs DC power and supplies the DC power to the AC load 4 or the DC load 5 through the power converter 10 and which stores the regenerative power inputted through the power converter 10. The battery 3 corresponds to one example of a power supply.

The AC load 4 is a device which is driven by the AC power supplied through the power converter 10. Specifically, the AC load 4 may be a traction motor. In the following description, the AC load 4 will be sometimes referred to as a "traction motor 4".

The traction motor 4 is a power source of a drive system of the motor vehicle 1 and is configured by, e.g., an IPM motor (Interior Permanent Magnet Motor). In Fig. 1, there is illustrated a case where the drive type of the drive system is a front-wheel drive type. However, this is not intended to limit the drive type of the motor vehicle 1.

The DC load 5 is a device which is driven by the low-voltage DC power supplied through the power converter 10. Specifically, the DC load 5 may be, e.g., a headlight, an indoor lamp, a car audio, or a car navigation system. In Fig. 1, for the sake of simplified illustration, the DC load 5 is schematically shown as a single rectangular solid.

The power converter 10 converts the DC power supplied from, e.g., the battery 3, to three-phase AC power and outputs the AC power to the traction motor 4. Furthermore, the power converter 10 steps down the voltage of the DC voltage and outputs the DC voltage to the DC load 5. Moreover, the power converter 10 returns the regenerative power generated during sudden deceleration of the traction motor 4 to the battery 3, thereby charging the battery 3. In case where the motor vehicle 1 is a hybrid motor vehicle, the power converter 10 charges the battery 3 with the electric power supplied from the traction motor 4 which serves as a generator during normal engine-driven running.

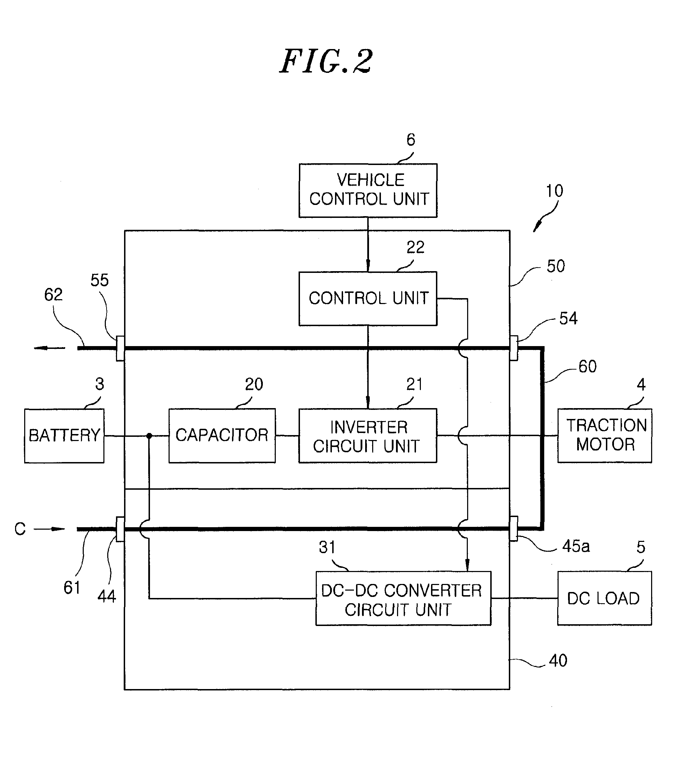

Next, the configuration of the power converter 10 will be described with reference to Fig. 2. Fig. 2 is a block diagram showing the configuration of the power converter 10. In Fig. 2 and the subsequent figures, there are shown only the components that are needed to describe the power converter 10 according to the present embodiment. Typical components such as a current detector and the like are not shown.

The power converter in accordance with the embodiment may include a DC-DC converter means and an inverter means. The DC-DC converter means and the inverter means may serve to change electrical characteristics of power supplied from a power supply. For instance, the power converter 10 illustrated in Fig. 2 includes a DC-DC converter circuit unit 31 and an inverter circuit unit 21 as examples of the DC-DC converter means and the inverter means.

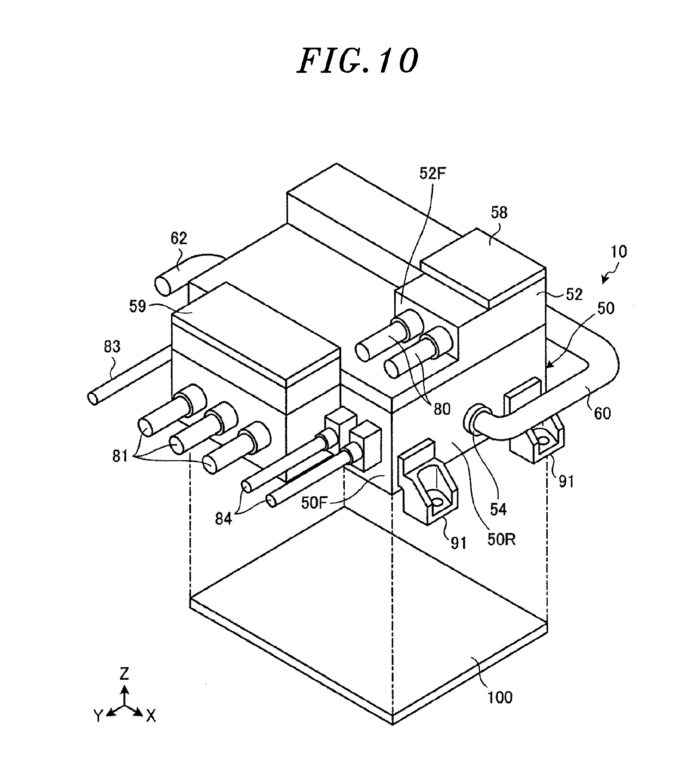

The power converter in accordance with the embodiment may further include a control means. For instance, as shown in Fig. 2, the power converter 10 includes a control unit 22 as one example of the control means. Besides, the power converter 10 illustrated in Fig. 10 further includes a capacitor 20. The capacitor 20 is connected to the battery 3 and is configured to supply stable DC power to the inverter circuit unit 21.

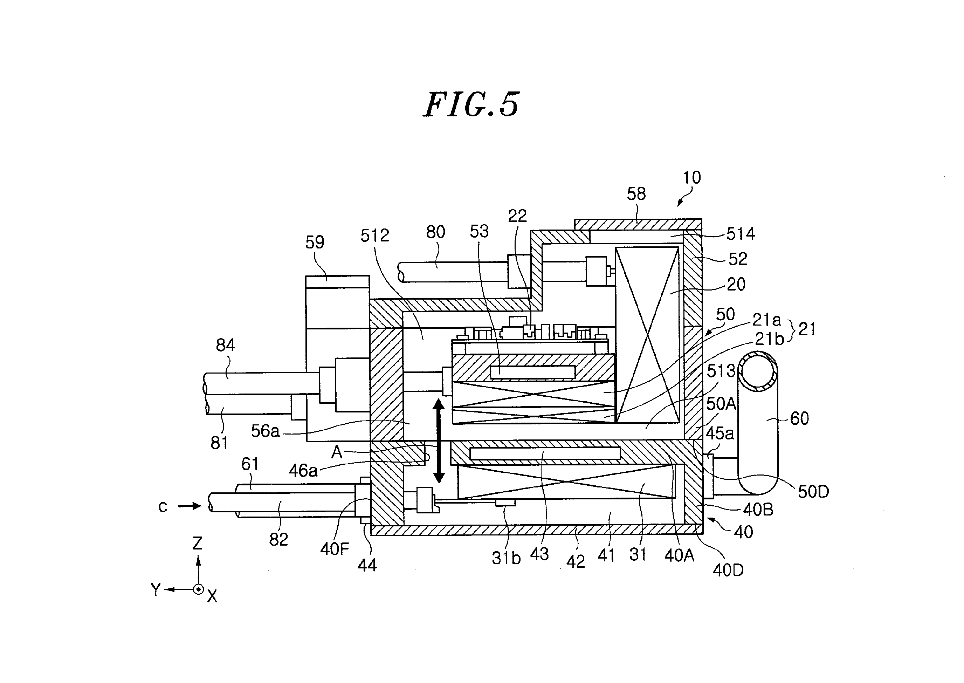

The inverter circuit unit 21 includes a power module 21a mounted with a switching element, e.g., an IGBT (Insulated Gate Bipolar Transistor) and a rectifying element, and a drive board 21b mounted with a drive circuit connected to the IGBT (see Fig. 5).

The control unit 22 includes a control board mounted with a control circuit (not shown). The control circuit of the control unit 22 controls the IGBT of the power module 21a through the drive circuit of the inverter circuit unit 21. Thus, the inverter circuit unit 21 converts DC power to three-phase AC power and outputs the three-phase AC power to the traction motor 4.

The DC-DC converter circuit unit 31 includes a converter module (not shown) mounted with a switching element, e.g., a MOSFET (Metal-Oxide-Semiconductor Field-Effect Transistor), a rectifying element and a voltage transformer, and a drive board (not shown) mounted with a drive circuit connected to the MOSFET.

The control circuit of the control unit 22 controls the MOSFET of the converter module through the drive circuit of the DC-DC converter circuit unit 31. Thus, the DC-DC converter circuit unit 31 steps down a voltage of the DC power with the voltage transformer and outputs the stepped-down DC power to the DC load 5.

As shown in Fig. 2, a vehicle control unit 6 for generally controlling the entire drive system of the motor vehicle 1 is connected to the control unit 22. Accordingly, the control unit 22 is controlled by the vehicle control unit 6.

In the foregoing description, the control unit 22 is configured to control both the inverter circuit unit 21 and the DC-DC converter circuit unit 31. However, the present disclosure is not limited thereto. For example, a converter control part may be provided independently of the control unit 22 such that the control unit 22 controls the inverter circuit unit 21 while the converter control part controls the DC-DC converter circuit unit 31.

In the foregoing description, the DC-DC converter circuit unit 31 is configured to step down the voltage of the DC power. However, the present disclosure is not limited thereto. For example, the DC-DC converter circuit unit 31 may be configured to step up the voltage of the DC power depending on the specifications of the DC load 5.

The power module 21a of the inverter circuit unit 21 and the converter module of the DC-DC converter circuit unit 31 generate heat during operation thereof. The power module 21a of the inverter circuit unit 21 drives the traction motor 4 by controlling a large current. For that reason, the power module 21a generates a large amount of heat and tends to become relatively hot.

In view of this, the power converter 10 according to the present embodiment is configured to efficiently and effectively cool the inverter circuit unit 21 and the DC-DC converter circuit unit 31. The configuration of the power converter 10 will now be described in detail.

Fig. 3A is a perspective view of the power converter 10. For the sake of making the description readily understandable, a three-dimensional rectangular coordinate system including a Z-axis whose positive direction extend vertically upward and whose negative direction extends vertically downward is sometimes indicated in the respective figures used in the following description. In the subject specification, the Y-axis positive direction in the rectangular coordinate system is defined as the front side of the power converter 10. The X-axis positive direction is defined as the right side of the power converter 10. The X-axis negative side is defined as the left side of the power converter 10. The embodiments may be described hereinafter by using the aforementioned directions, which is not for limiting the scope of the present teachings, but merely for the making the description readily understandable.

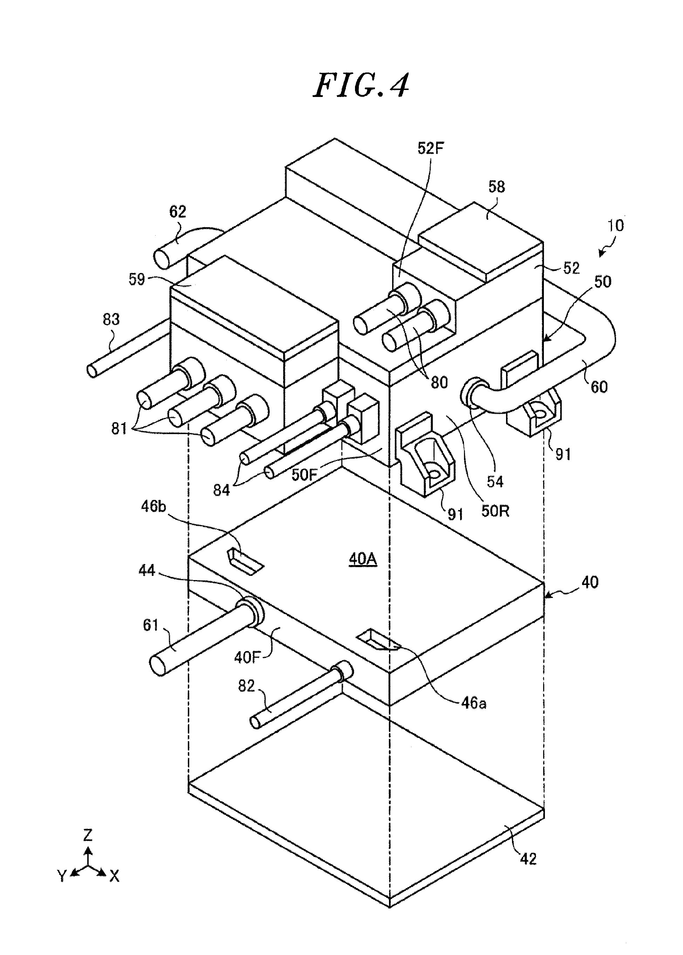

Fig. 3B is a rear perspective view of the power converter 10 shown in Fig. 3A. Fig. 4 is an exploded perspective view of the power converter 10 shown in Fig. 3A. Fig. 5 is a sectional view taken along line V-V in Fig. 3A.

As shown in Figs. 3A to 5, the power converter 10 includes a first accommodation part 40 and a second accommodation part 50. As depicted in Fig. 5, the first accommodation part 40 accommodates the DC-DC converter circuit unit 31 and so forth.

The second accommodation part 50 accommodates the capacitor 20, the inverter circuit unit 21, the control unit 22 and so forth. The first accommodation part 40 corresponds to one example of a DC-DC converter accommodation part. The second accommodation part 50 corresponds to one example of an inverter accommodation part.

Each of the first accommodation part 40 and the second accommodation part 50 is a casting formed into a rectangular solid shape or a substantially rectangular solid shape. The first accommodation part 40 and the second accommodation part 50 are unitarily coupled to each other. Specifically, for example, an upper surface (a first coupling surface) 40A of the first accommodation part 40 and a lower end 50A of the second accommodation part 50 are disposed so as to make contact with each other and are fixed and coupled to each other by fixing members (e.g., bolts) (not shown). Thus, in the power converter 10, the first accommodation part 40 is positioned at the lower side while the second accommodation part 50 is positioned at the upper side.

As shown in Fig. 5, a first opening portion 41 is formed on a lower surface 40D of the first accommodation part 40. A first cover 42 is attached to the first opening portion 41. This makes it possible to prevent dust or water from entering the internal space of the first accommodation part 40 which accommodates the DC-DC converter circuit unit 31 and so forth.

In the meantime, a second opening portion 512 is formed on an upper surface of the second accommodation part 50. A third opening portion 513 is formed on a lower surface (a second coupling surface) 50D of the second accommodation part 50. A second cover 52 is attached to the second opening portion 512. As the first accommodation part 40 and the second accommodation part 50 are coupled to each other, the third opening portion 513 is closed by the upper surface 40A of the first accommodation part 40. This makes it possible to prevent dust or water from entering the internal space of the second accommodation part 50 which accommodates the inverter circuit unit 21 and so forth.

The power converter in accordance with the embodiment may further include a first cooling means and a second cooling means for cooling the DC-DC converter means and the inverter means (e.g., the DC-DC converter circuit unit 31 and the inverter circuit unit 21).

As one example of the first cooling means, a first flow path portion 43 is provided. As illustrated in Fig. 5, the first flow path portion 43 through which a cooling medium C flows is formed within the first accommodation part 40. In the first accommodation part 40, the first flow path portion 43 is disposed at such a position where the first flow path portion 43 can efficiently and effectively cool the DC-DC converter circuit unit 31 and the like. On this point, description will be made later. In the following description, the cooling medium C will be sometimes referred to as "cooling water". The "cooling water" is one example of cooling liquid including water and cooling medium C other than water. Alternatively, in some embodiments, the cooling medium may be a gaseous material such as air and the like.

One end of the first flow path portion 43 is connected to a cooling water inlet portion 44 formed on a front surface 40F of the first accommodation part 40 (see Fig. 4). The other end of the first flow path portion 43 is connected a first cooling water outlet portion 45a formed on a rear surface 40B of the first accommodation part 40 (see Fig. 3B). That is to say, in the first accommodation part 40, the cooling water inlet portion 44 and the first cooling water outlet portion 45a are connected through the first flow path portion 43.

In addition to the first cooling water outlet portion 45a, a second cooling water outlet portion 45b is formed on the rear surface 40B of the first accommodation part 40. The first flow path portion 43 is not connected to the second cooling water outlet portion 45b. For that reason, there is no possibility that the cooling water flows out from the second cooling water outlet portion 45b. The second cooling water outlet portion 45b will be described later in detail.

As one example of the second cooling means, a second flow path portion 53 is provided. As shown in Fig. 5, a second flow path portion 53 through which the cooling medium C flows is formed within the second accommodation part 50. In the second accommodation part 50, the second flow path portion 53 is positioned at such a position where the second flow path portion 53 can efficiently and effectively cool the inverter circuit unit 21, the control unit 22 and so forth. On this point, description will be made later.

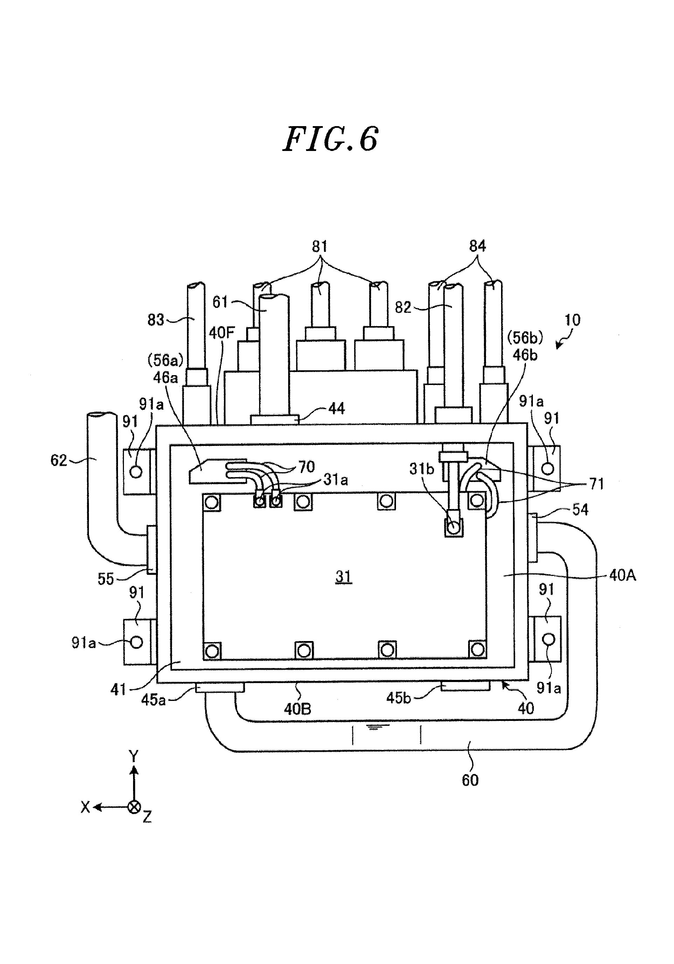

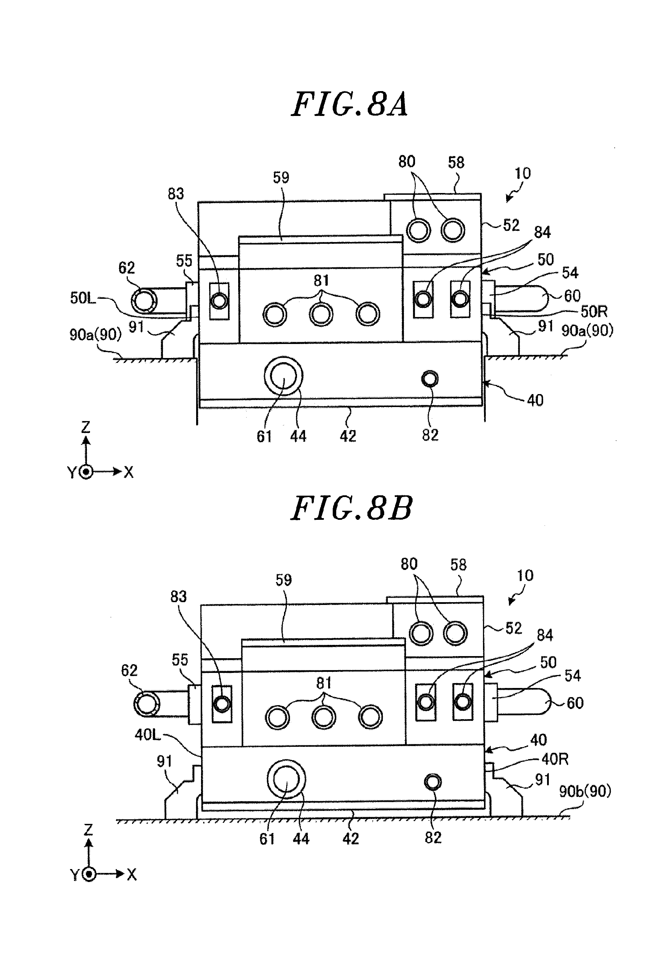

One end of the second flow path portion 53 is connected to a cooling water inlet portion 54 formed on a right side surface 50R of the second accommodation part 50 (see Figs. 3A and 3B). The other end of the second flow path portion 53 is connected to a cooling water outlet portion 55 formed on a left side surface 50L of the second accommodation part 50 (see Figs. 6 and 8A to be described later). That is to say, in the second accommodation part 50, the cooling water inlet portion 54 and the cooling water outlet portion 55 are connected through the second flow path portion 53.

The first cooling water outlet portion 45a of the first accommodation part 40 and the cooling water inlet portion 54 of the second accommodation part 50 are connected through a connecting pipe 60. A water supply pipe 61 is connected to the cooling water inlet portion 44 of the first accommodation part 40. A water discharge pipe 62 is connected to the cooling water outlet portion 55 of the second accommodation part 50.

The water supply pipe 61 is connected to a discharge port of a cooling water circulating pump (not shown) through a radiator (not shown). On the other hand, the water discharge pipe 62 is connected to an intake port of the pump. Thus, the cooling water is first sent from the pump to the radiator where heat is dissipated. Thereafter, the cooling water is supplied to the first flow path portion 43 through the water supply pipe 61 and the cooling water inlet portion 44.

The cooling water flowing through the first flow path portion 43 is discharged from the first cooling water outlet portion 45a and is supplied to the second flow path portion 53 through the connecting pipe 60 and the cooling water inlet portion 54. Thereafter, the cooling water flowing through the second flow path portion 53 is discharged from the cooling water outlet portion 55 and is returned back to the pump through the water discharge pipe 62.

In this way, the cooling water flows from the first flow path portion 43 positioned at the lower side toward the second flow path portion 53 positioned at the upper side. Thus, an air is less likely to stay in the first and second flow path portions 43 and 53 or the respective pipes 60, 61 and 62. This makes it possible to reliably perform circulation of the cooling water.

In the foregoing description, the cooling water flows in the order of the first flow path portion 43 and the second flow path portion 53. However, the present disclosure is not limited thereto. For example, the cooling water may be allowed to flow in the order of the second flow path portion 53 and the first flow path portion 43.

In the foregoing description, the first flow path portion 43 and the second flow path portion 53 are serially connected through the connecting pipe 60. However, the present disclosure is not limited thereto. For example, the first flow path portion 43 and the second flow path portion 53 may be respectively connected to the cooling water circulating pump. In other words, the first flow path portion 43 and the second flow path portion 53 may be parallel-connected to the cooling water circulating pump. In this case, one cooling water circulating pump may be used in common for the first flow path portion 43 and the second flow path portion 53. Alternatively, different pumps may be used for the first flow path portion 43 and the second flow path portion 53.

Now, the arrangement of the DC-DC converter means, the inverter means, the first cooling means, the second cooling means, and the control means in accordance with the embodiment will be described with reference to Fig. 5.

The first cooling means may be disposed between the DC-DC converter means and the inverter means, and the second cooling means may be disposed at an opposite side of the inverter means from a side at which the first cooling means is disposed. In some embodiments, it can be said that the DC-DC converter means, the first cooling means, the inverter means, and the second cooling means may be disposed in that order. Based on the aforementioned arrangement, the DC-DC converter means, the first cooling means, the inverter means, and the second cooling means may be disposed to form a layered structure.

Fig. 5 shows one example of the aforementioned arrangement of the DC-DC converter means (e.g., the DC-DC converter circuit unit 31), the inverter means (e.g., the inverter circuit unit 21), the control means (e.g., the control unit 22), the first cooling means (e.g., the first flow path portion 43), and the second cooling means (e.g., the second flow path portion 53) in the power converter 10

As shown in Fig. 5, in the power converter 10, the first flow path portion 43 may be disposed between the DC-DC converter circuit unit 31 and the inverter circuit unit 21, and the second flow path portion 53 may be disposed at an opposite side of the inverter circuit unit 21 from a side at which the first flow path portion 43 is disposed. Further, the control unit 22 may be disposed at an opposite side of the second flow path portion 53 from a side at which the inverter circuit unit 21 is disposed. In the embodiment, it can be said that the DC-DC converter circuit unit 31, the first flow path portion 43, the inverter circuit unit 21, the second flow path portion 53, and the control unit 22 are disposed in that order from the lower side.

Based on the aforementioned arrangement, the DC-DC converter circuit unit 31, the first flow path portion 43, the inverter circuit unit 21, the second flow path portion 53, and the control unit 22 may be stacked one above another. In other words, when seen in a vertical axis direction, the DC-DC converter circuit unit 31, the first flow path portion 43, the inverter circuit unit 21, the second flow path portion 53 and the control unit 22 are disposed such that the occupying areas thereof on an XY plane wholly or partially overlap with one another.

The DC-DC converter circuit unit 31 is disposed in close contact with the first flow path portion 43. The inverter circuit unit 21 is configured by the drive board 21b and the power module 21a stacked in that order from the lower side. The inverter circuit unit 21 is disposed in contact with the second flow path portion 53, e.g., such that the power module 21a makes close contact with the second flow path portion 53.

It is therefore possible to efficiently and effectively cool the inverter circuit unit 21 and the DC-DC converter circuit unit 31. That is to say, the DC-DC converter circuit unit 31 can be cooled by the first flow path portion 43 while the inverter circuit unit 21 can be cooled by the second flow path portion 53.

Since the first flow path portion 43 is interposed between the DC-DC converter circuit unit 31 and the inverter circuit unit 21, it is possible to suppress, at the maximum, the influence of heat received by the DC-DC converter circuit unit 31 from the inverter circuit unit 21 (e.g., the power module 21a) that generates a large amount of heat. Similarly, it is possible to suppress, at the maximum, the influence of heat received by the inverter circuit unit 21 from the DC-DC converter circuit unit 31. Since the inverter circuit unit 21 and the DC-DC converter circuit unit 31 can be cooled efficiently and effectively, it is possible to enhance the reliability of the operations of the respective circuit units 21 and 31.

As described above, in the power converter 10, the inverter circuit unit 21, the second flow path portion 53 and the control unit 22 are disposed within the second accommodation part 50 in that order from the lower side. That is to say, the control unit 22 is disposed at the opposite side (the upper side) of the second flow path portion 53 from the side (the lower side) at which the inverter circuit unit 21 is disposed. The control unit 22 is disposed in close contact with the second flow path portion 53.

This makes it possible to cool the control unit 22 with the second flow path portion 53. Since the second flow path portion 53 is interposed between the control unit 22 and the inverter circuit unit 21, it is possible to suppress, at the maximum, the influence of heat received by the control unit 22 from the inverter circuit unit 21 that generates a large amount of heat.

In the first accommodation part 40, the DC-DC converter circuit unit 31 and the first flow path portion 43 are disposed in the aforementioned order. For that reason, the first opening portion 41 is formed on the surface of the first accommodation part 40 at the side (the lower side) of the first flow path portion 43 at which the DC-DC converter circuit unit 31 is disposed.

Thus, the inspection of the DC-DC converter circuit unit 31 can be easily performed at the side of the first opening portion 41 of the first accommodation part 40. This makes it possible to improve the maintainability.

In the second accommodation part 50, the inverter circuit unit 21, the second flow path portion 53 and the control unit 22 are disposed in the aforementioned order. For that reason, the second opening portion 512 is formed on the surface of the second accommodation part 50 at the side (the upper side) of the inverter circuit unit 21 at which the second flow path portion 53 is formed.

Since the control unit 22 is disposed at the upper side of the second flow path portion 53, the inspection of the control unit 22 can be easily performed at the side of the second opening portion 512 of the second accommodation part 50. This makes it possible to improve the maintainability.

The third opening portion 513 is formed on the surface of the second accommodation part 50 at the side (the lower side) of the second flow path portion 53 at which the inverter circuit unit 21 is disposed. Thus, the inspection of the inverter circuit unit 21 can be easily performed at the side of the third opening portion 513 of the second accommodation part 50 after the first accommodation part 40 is removed. This makes it possible to further improve the maintainability.

As described above, the first accommodation part 40 is coupled to and unified with the second accommodation part 50. That is to say, at the pre-coupling stage, the first accommodation part 40 is separated from the second accommodation part 50.

This makes it possible to further improve the quality of the power converter 10. For example, when the first accommodation part 40 and the second accommodation part 50 is kept in a separated state, it is possible to individually inspect the quality of the DC-DC converter circuit unit 31 of the first accommodation part 40 and the qualities of the control unit 22 and the inverter circuit unit 21 of the second accommodation part 50 at the sides of the respective opening portions 41, 512 and 513.

In other words, during the assembling stage of the power converter 10, it is possible to inspect the qualities of the respective circuit units 21 and 31 and the control unit 22. Since the power converter 10 is manufactured by coupling the first accommodation part 40 and the second accommodation part 50 which have already been subjected to inspection, it is possible to further improve the quality of the power converter 10.

Inasmuch as the first accommodation part 40 is separable from the second accommodation part 50, the power converter 10 may be configured by, e.g., only the second accommodation part 50 which includes the inverter circuit unit 21 and so forth. On this point, description will be made later.

The first and second flow path portions 43 and 53 are made of a metallic material. As the material of the first and second flow path portions 43 and 53, it may be possible to use, e.g., aluminum. However, the material of the first and second flow path portions 43 and 53 is not limited thereto.

Thus, the first and second flow path portions 43 and 53 can shield the noises generated from the inverter circuit unit 21, the control unit 22 and the DC-DC converter circuit unit 31. Accordingly, in the power converter 10, the transfer of noises from the inverter circuit unit 21 to the DC-DC converter circuit unit 31 and the transfer of noises from the DC-DC converter circuit unit 31 to the inverter circuit unit 21 can be suppressed by the first flow path portion 43.

Similarly, in the power converter 10, the transfer of noises from the inverter circuit unit 21 to the control unit 22 and the transfer of noises from the control unit 22 to the inverter circuit unit 21 can be suppressed by the second flow path portion 53.

Next, description will be made on the coupling portion of the first accommodation part 40 and the second accommodation part 50. Fig. 6 is a bottom view of the power converter 10 with the first cover 42 removed. As shown in Figs. 4 to 6, a plurality of, e.g., two, communication holes 46a and 46b is formed on the upper surface 40A of the first accommodation part 40 (In Fig. 5, the communication hole 46b is not shown).

While the first accommodation part 40 is configured to have two communication holes 46a and 46b in the foregoing description, this is illustrative and not limitative. That is to say, the first accommodation part 40 may be configured to have one communication hole or three or more communication holes. However, it is preferred that the first accommodation part 40 has two or more communication holes. In the following description, one of the communication holes 46a and 46b will be sometimes referred to as a "first converter-side communication hole 46a" while the other will be sometimes referred to as a "second converter-side communication hole 46b".

The first and second converter-side communication holes 46a and 46b are formed on the upper surface 40A of the first accommodation part 40 in the end portion at the side of the front surface 40F and are spaced apart from each other by a predetermined distance. The predetermined distance may be set arbitrarily.

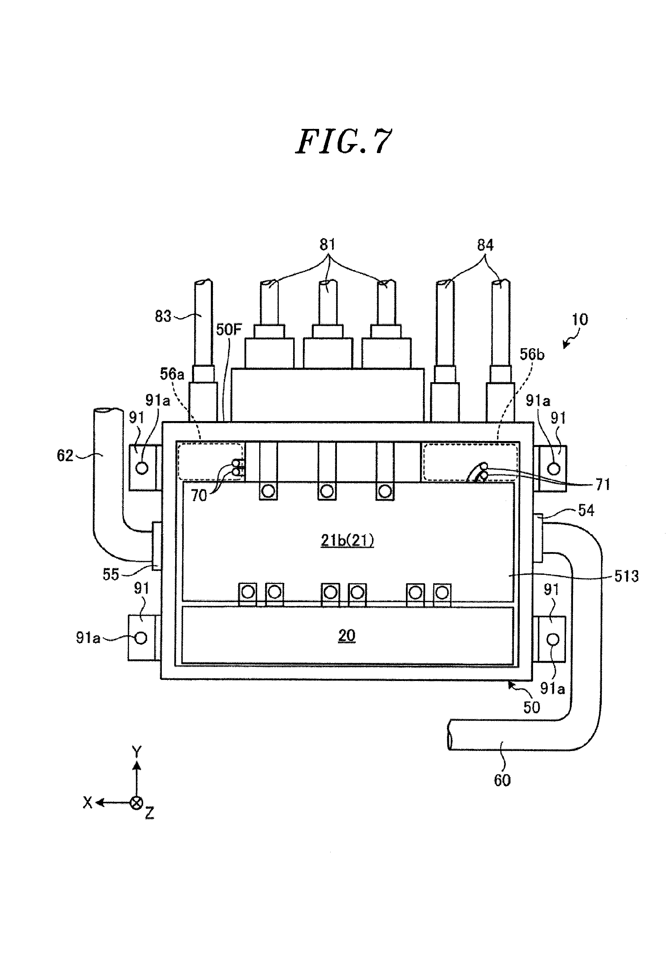

Fig. 7 is a bottom view of the power converter 10 with the first accommodation part 40 removed from the second accommodation part 50. As shown in Fig. 7, the second accommodation part 50 has a plurality of, e.g., two, communication holes 56a and 56b. It is preferred that the number of the communication holes of the second accommodation part 50 is equal to, e.g., the number of the communication holes of the first accommodation part 40 (two in the present embodiment).

The communication holes 56a and 56b are the spaces which constitute the internal space of the second accommodation part 50 and in which the second flow path portion 53 (not shown in Fig. 7) is not disposed. More specifically, the communication holes 56a and 56b are the spaces which constitute the third opening portion 513 of the second accommodation part 50 and in which the second flow path portion 53, the inverter circuit unit 21 and the capacitor 20 are not disposed when seen in a vertical axis direction. As mentioned above, the communication holes 56a and 56b are specific spaces which constitute the internal space of the second accommodation part 50. Thus, the communication holes 56a and 56b are indicated by broken lines in Fig. 7.

The communication hole 56a is formed in the third opening portion 513 at a position corresponding to the first converter-side communication hole 46a. The communication hole 56b is formed in the third opening portion 513 at a position corresponding to the second converter-side communication hole 46b.

In the following description, the communication hole 56a corresponding to the first converter-side communication hole 46a will be sometimes referred to as a "first inverter-side communication hole 56a". The communication hole 56b corresponding to the second converter-side communication hole 46b will be sometimes referred to as a "second inverter-side communication hole 56b".

Thus, as indicated by an arrow A in Fig. 5, the internal space of the first accommodation part 40 and the internal space of the second accommodation part 50 are brought into communication with each other by the first converter-side communication hole 46a and the first inverter-side communication hole 56a. Similarly, the internal spaces of the respective accommodation parts 40 and 50 are brought into communication with each other by the second converter-side communication hole 46b and the second inverter-side communication hole 56b.

Wiring lines extending between the first accommodation part 40 and the second accommodation part 50 pass through the first converter-side communication hole 46a and the first inverter-side communication hole 56a and through the second converter-side communication hole 46b and the second inverter-side communication hole 56b.

More specifically, as shown in Figs. 6 and 7, for example, a power supply line 70 for supplying DC power from the battery 3 to the DC-DC converter circuit unit 31 passes through the communication holes 46a and 56a. As an example, one end of the power supply line 70 is connected to a power supply line between the battery 3 and the capacitor 20 in the internal space of the second accommodation part 50. The other end of the power supply line 70 is connected to an input terminal 31a of the DC-DC converter circuit unit 31 of the first accommodation part 40.

For example, a signal line 71 for interconnecting the control unit 22 of the second accommodation part 50 and the DC-DC converter circuit unit 31 of the first accommodation part 40 passes through the communication holes 46b and 56b.

That is to say, the first converter-side communication hole 46a and the first inverter-side communication hole 56a are communication holes for power supply wiring lines. The second converter-side communication hole 46b and the second inverter-side communication hole 56b are communication holes for signal wiring lines.

In this way, the wiring of the power supply line 70 and the signal line 71 is performed through the communication holes 46a, 56a, 46b and 56b formed in the first accommodation part 40 and the second accommodation part 50, i.e., in the side of the first and second accommodation parts 40 and 50. It is therefore possible to easily perform a wiring process. Moreover, as compared with a case where wiring is performed so as to go around the outside of the first and second accommodation parts 40 and 50, it is possible to shorten the length of the power supply line 70 and the signal line 71. This is advantageous in terms of the cost-effectiveness.

The first accommodation part 40 has two communication holes 46a and 46b and the second accommodation part 50 has two communication holes 56a and 56b. Thus, as described above, the communication holes 46a and 56a and the communication holes 46b and 56b can be properly used, depending the intended use of wiring lines. This makes it possible to restrain the power supply line 70 and the signal line 71 from interfering with each other by noises.

In the foregoing description, the power supply line 70 and the signal line 71 are illustrated as the kinds of wiring lines passing through the respective communication holes 46a, 56a, 46b and 56b. However, the kinds of wiring lines are not limited thereto. In addition, the signal line 71 may be arranged to pass through the communication holes 46a and 56a and the power supply line 70 may be arranged to pass through the communication holes 46b and 56b.

The power converter 10 will be further described below. As shown in Figs. 3A and 4, various kinds of cables are connected to the power converter 10. More specifically, in the power converter 10, various kinds of cables are connected to the front surfaces 40F and 50F of the first and second accommodation parts 40 and 50 and the front surface 52F of the second cover 52.

Specifically, a battery cable 80 for interconnecting the battery 3 and the power converter 10 is connected to the front surface 52F of the second cover 52. Furthermore, a motor cable 81 for interconnecting the inverter circuit unit 21 of the power converter 10 and the traction motor 4 is connected to the front surface 50F of the second accommodation part 50.

As shown in Fig. 5, a fourth opening portion 514 is formed near a position corresponding to the portion of the second cover 52 to which the battery cable 80 is connected. A battery cable cover 58 is attached to the fourth opening portion 514.

While not specifically shown, an opening portion is also formed near a position corresponding to the portion of the second cover 52 to which the motor cable 81 is connected. A motor cable cover 59 is attached to this opening portion.

Thus, the works of connecting the battery cable 80 and the motor cable 81 can be easily performed by merely removing the battery cable cover 58 and the motor cable cover 59 without removing the second cover 52 having a relatively large size.

Moreover, the inspection of the portion to which the battery cable 80 is connected and the inspection of the portion to which the motor cable 81 is connected can be performed by removing the battery cable cover 58 and the motor cable cover 59. It is therefore possible to further enhance the maintainability of the power converter 10.

A DC output cable 82 for interconnecting the DC-DC converter circuit unit 31 of the power converter 10 (specifically, the output terminal 31b of the DC-DC converter circuit unit 31) (see Fig. 6) and the DC load 5 is connected to the front surface 40F of the first accommodation part 40.

A control unit cable 83 for interconnecting the vehicle control unit 6 and the control unit 22 of the power converter 10 and a motor control cable 84 for interconnecting the traction motor 4 and the control unit 22 of the power converter 10 are connected to the front surface 50F of the second accommodation part 50.

As described above, in the power converter 10, the surfaces to which various kinds of cables are connected are concentrated on the front surfaces 40F, 50F and 52F. Thus, the works of connecting the cables can be performed only at the side of the front surfaces 40F, 50F and 52F. It is therefore possible to increase the efficiency of the connecting works.

The power converter 10 configured as above is attached to a suitable position of the motor vehicle 1. The attachment of the power converter 10 to the motor vehicle 1 will now be described with reference to Fig. 8A and other figures.

Fig. 8A is a front view showing one example of a state in which the power converter 10 is attached to a specified target attachment position 90 of the motor vehicle 1.

In the example shown in Fig. 8A, a bracket 90a is used as the target attachment position 90. In the power converter 10, two attachment portions 91 are formed on each of the right side surface 50R and the left side surface 50L of the second accommodation part 50 (In Fig. 8A, two attachment portions are not visible).

As best shown in Fig. 6, the attachment portions 91 are formed such that they are positioned around four corners of the second accommodation part 50 when seen in a vertical axis direction. Insertion holes 91a into which fixing members (e.g., bolts) (not shown) can be inserted are formed in the attachment portions 91.

As shown in Fig. 8A, the power converter 10 is attached to the motor vehicle 1 by inserting the fixing members into the insertion holes 91a in a state in which the power converter 10 is supported on the bracket 90a through the attachment portions 91.

As described above, the power converter 10 is provided with the attachment portions 91. This makes it possible to easily perform the attachment of the power converter 10 to the target attachment position 90 of the motor vehicle 1. The number of the attachment portions 91 and the formation positions of the attachment portions 91 described above are merely illustrative rather than limitative and may be changed depending on the shape of the target attachment position 90, etc.

The attachment of the power converter 10 to the motor vehicle 1 is not limited to the example shown in Fig. 8A. A modified example of the attachment of the power converter 10 to the motor vehicle 1 will be described with reference to Fig. 8B. Fig. 8B is a front view showing a modified example of the attachment of the power converter 10 to the motor vehicle 1.

In the examples shown in Fig. 8B, the target attachment position 90 is a planar target attachment surface 90b. In this case, the attachment portions 91 of the power converter 10 are formed in the first accommodation part 40 positioned below the second accommodation part 50. More specifically, in the power converter 10, two attachment portions 91 are formed on each of the right side surface 40R and the left side surface 40L of the first accommodation part 40 (In Fig. 8B, two attachment portions are not visible).

As shown in Fig. 8B, the power converter 10 is attached to the motor vehicle 1 by inserting the fixing members into the insertion holes 91a in a state in which the power converter 10 is supported on the target attachment surface 90b through the attachment portions 91.

Even if the target attachment position 90 is the flat target attachment surface 90b, the power converter 10 can be easily attached to the target attachment position 90 of the motor vehicle 1 by providing the attachment portions 91 to the first accommodation part 40.

In the examples shown in Figs. 8A and 8B, the attachment portions 91 are provided to the second accommodation part 50 or the first accommodation part 40. However, the present disclosure is not limited thereto. For example, the attachment portions 91 may be previously provided to both of the first and second accommodation parts 40 and 50. Depending on the shape of the target attachment position 90, one of the attachment portions 91 of the first accommodation part 40 and the attachment portions 91 of the second accommodation part 50 may be cut away by a cutting work.

More specifically, for example, if the target attachment position 90 is the bracket 90a, the attachment portions 91 of the first accommodation part 40 are cut away by a cutting work. Thus, the power converter 10 can be attached to the bracket 90a through the remaining attachment portions 91 of the second accommodation part 50.

On the other hand, for example, if the target attachment position 90 is the target attachment surface 90b, the attachment portions 91 of the second accommodation part 50 are cut away by a cutting work. Thus, the power converter 10 can be attached to the target attachment surface 90b through the remaining attachment portions 91 of the first accommodation part 40. In the foregoing description, unnecessary attachment portions 91 are cut away. However, the present disclosure is not limited thereto. It may be possible to leave unnecessary attachment portions 91 as they are.

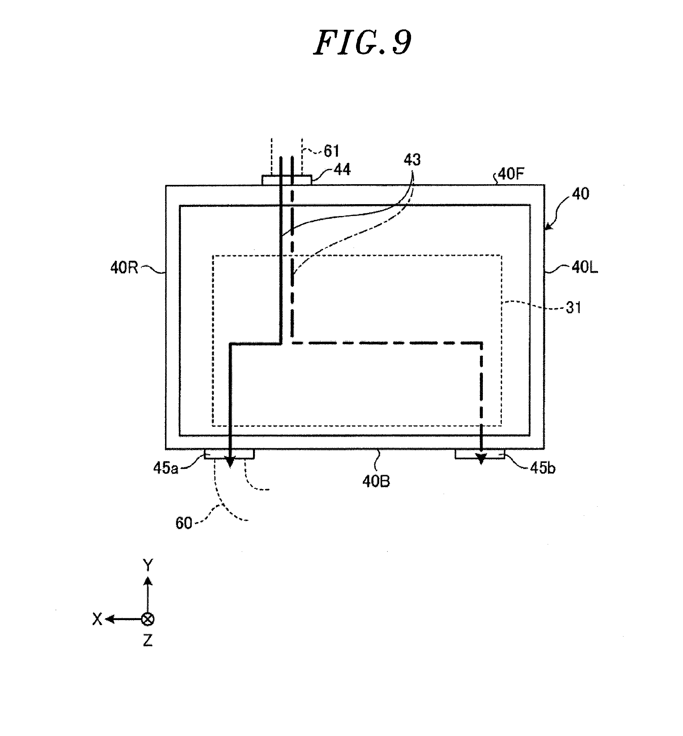

Next, the connection relationship between the cooling water inlet portion 44, the first cooling water outlet portion 45a and the second cooling water outlet portion 45b of the first accommodation part 40 will be described in detail. Fig. 9 is a view explaining the connection relationship between the cooling water inlet portion 44, the first cooling water outlet portion 45a and the second cooling water outlet portion 45b of the first accommodation part 40.

As shown in Fig. 9, the cooling water inlet portion 44 is formed on the front surface 40F of the first accommodation part 40. The first cooling water outlet portion 45a and the second cooling water outlet portion 45b are formed on the rear surface 40B of the first accommodation part 40. The first cooling water outlet portion 45a is positioned near the right side surface 40R while the second cooling water outlet portion 45b is positioned near the left side surface 40L.

As already mentioned above, the cooling water inlet portion 44 and the first cooling water outlet portion 45a are connected through the first flow path portion 43. Accordingly, the cooling water supplied from the water supply pipe 61 is discharged from the first cooling water outlet portion 45a after passing through the cooling water inlet portion 44 and the first flow path portion 43, and is introduced into the connecting pipe 60 connected to the first cooling water outlet portion 45a.

However, depending on the attachment position of the power converter 10 in the motor vehicle 1, there may be a case where a space for arranging the connecting pipe 60 does not exist near the first cooling water outlet portion 45a.

In view of this, the first accommodation part 40 of the power converter 10 according to the present embodiment is configured such that the cooling water can be discharged from the second cooling water outlet portion 45b.

More specifically, for example, if a space for arranging the connecting pipe 60 does not exist near the first cooling water outlet portion 45a, a core for forming the first flow path portion 43 is first replaced in a mold used in molding the first accommodation part 40. More specifically, a core formed so as to enable the first flow path portion 43 to interconnect the cooling water inlet portion 44 and the first cooling water outlet portion 45a is replaced by a core formed so as to enable the first flow path portion 43 to interconnect the cooling water inlet portion 44 and the second cooling water outlet portion 45b.

By using the mold in which the core is replaced as mentioned above, it is possible to easily manufacture the first accommodation part 40 in which the cooling water inlet portion 44 and the second cooling water outlet portion 45b are connected through the first flow path portion 43 as indicated by an imaginary line in Fig. 9. In this case, the cooling water supplied from the water supply pipe 61 is discharged from the second cooling water outlet portion 45b after passing through the cooling water inlet portion 44 and the first flow path portion 43.

While not shown in the drawings, if the connecting pipe 60 originally connected to the first cooling water outlet portion 45a is connected to the second cooling water outlet portion 45b, the cooling water discharged from the second cooling water outlet portion 45b passes through the connecting pipe 60 and flows toward the cooling water inlet portion 54 of the second accommodation part 50. In Fig. 9, for the sake of easier understanding, the shape of the first flow path portion 43 is shown in a simplified manner.

As described above, in the first accommodation part 40, there are provided the first cooling water outlet portion 45a and the second cooling water outlet portion 45b so that one of the cooling water outlet portions can be selected depending on the attachment position of the power converter 10. This makes it possible to appropriately arrange, e.g., the connecting pipe 60 depending on the attachment position of the power converter 10.

In the foregoing description, the first accommodation part 40 and the like are manufactured by a casting method using a mold. However, the present disclosure is not limited thereto. The first accommodation part 40 and the like may be manufactured by other molding methods.

In the foregoing description, the cooling water enters the cooling water inlet portion 44 and comes out from the first cooling water outlet portion 45a or the second cooling water outlet portion 45b. However, the present disclosure is not limited thereto. For example, the cooling water inlet portion 44 may be allowed to serve as a cooling water outlet. The first and second cooling water outlet portions 45a and 45b may be allowed to serve as cooling water inlets.

Specifically, for example, the water supply pipe 61 may be connected to the first cooling water outlet portion 45a and the connecting pipe 60 may be connected to the cooling water inlet portion 44. In this case, the cooling water flows through the water supply pipe 61, the first cooling water outlet portion 45a, the first flow path portion 43, the cooling water inlet portion 44 and the connecting pipe 60 in that order.

As another example, the water supply pipe 61 may be connected to the first cooling water outlet portion 45a and the connecting pipe 60 may be connected to the second cooling water outlet portion 45b. In this case, if the core of the mold is replaced by a suitable one, the cooling water flows through the water supply pipe 61, the first cooling water outlet portion 45a, the first flow path portion 43, the second cooling water outlet portion 45b and the connecting pipe 60 in that order.

As described above, in the first accommodation part 40, the cooling water inlet portion 44 and the first cooling water outlet portion 45a and the second cooling water outlet portion 45b may be regarded as outlet/inlet portions which have functions of both of an inlet and an outlet. Accordingly, the first accommodation part 40 includes three outlet/inlet portions, namely the cooling water inlet portion 44, the first cooling water outlet portion 45a and the second cooling water outlet portion 45b. By connecting two of the three outlet/inlet portions through the first flow path portion 43, it is possible to increase the degree of freedom of the arrangement layout of the water supply pipe 61 and the connecting pipe 60 in the first accommodation part 40.

In the foregoing description, the first accommodation part 40 includes three outlet/inlet portions, namely the cooling water inlet portion 44, the first cooling water outlet portion 45a and the second cooling water outlet portion 45b. However, the present disclosure is not limited thereto. The first accommodation part 40 may include four or more outlet/inlet portions. In the first accommodation part 40, the outlet/inlet portions are provided on the front surface 40F and the rear surface 40B. However, the present disclosure is not limited thereto. For example, the outlet/inlet portions may be provided on the right side surface 40R or the left side surface 40L.

Similarly, in the second accommodation part 50, the cooling water inlet portion 54 may be allowed to serve as a cooling water outlet and the cooling water outlet portion 55 may be allowed to serve as a cooling water inlet. In this case, the connecting pipe 60 is connected to the cooling water outlet portion 55 while the water discharge pipe 62 is connected to the cooling water inlet portion 54. The cooling water flows through the connecting pipe 60, the cooling water outlet portion 55, the second flow path portion 53, the cooling water inlet portion 54 and the water discharge pipe 62 in that order.

As described above, in the second accommodation part 50, just like the first accommodation part 40, the cooling water inlet portion 54 and the cooling water outlet portion 55 may be regarded as outlet/inlet portions which have functions of both of an inlet and an outlet. Accordingly, in the second accommodation part 50, one of the cooling water inlet portion 54 and the cooling water outlet portion 55 may be used as an inlet and the other may be used as an outlet depending on, e.g., the specifications of the motor vehicle 1. This makes it possible to increase the degree of freedom of the arrangement layout of the connecting pipe 60 and the water discharge pipe 62.

In the foregoing description, the second accommodation part 50 includes two outlet/inlet portions, namely the cooling water inlet portion 54 and the cooling water outlet portion 55. However, the present disclosure is not limited thereto. The second accommodation part 50 may include three or more outlet/inlet portions. In this case, it is preferred that two of the three or more outlet/inlet portions are connected by the second flow path portion 53.

As described above, the power converter 10 according to the present embodiment includes the DC-DC converter circuit unit 31, the inverter circuit unit 21, the first flow path portion 43 and the second flow path portion 53. The DC-DC converter circuit unit 31 steps up or steps down the voltage of the DC power supplied from the battery 3. The inverter circuit unit 21 converts the DC power to AC power. The first flow path portion 43 and the second flow path portion 53 are configured such that the cooling medium C flows through the first flow path portion 43 and the second flow path portion 53. The DC-DC converter circuit unit 31, the first flow path portion 43, the inverter circuit unit 21 and the second flow path portion 53 are stacked one above another in that order and are disposed so as to overlap with one another.

Thus, according to the power converter 10 of the present embodiment, it is possible to efficiently and effectively cool the inverter circuit unit 21 and the DC-DC converter circuit unit 31.

Next, a modified example of the power converter 10 according to the present embodiment will be described with reference to Fig. 10. Fig. 10 is an exploded perspective view showing a power converter 10 according to a modified example.

As described above, the first accommodation part 40 is separable from the second accommodation part 50. Depending on the specifications of the motor vehicle 1, there may be a case where a DC-DC converter is mounted to the motor vehicle 1 in advance and the first accommodation part 40 including the DC-DC converter circuit unit 31 is not needed in the power converter 10.

Thus, in the power converter 10 of the modified example, as shown in Fig. 10, the first accommodation part 40 is removed from the second accommodation part 50. The power converter 10 includes only the second accommodation part 50 provided with the inverter circuit unit 21. Fig. 10 shows the power converter 10 in which the first accommodation part 40 is removed from the second accommodation part 50.

In this way, the power converter 10 according to the modified example can easily cope with the specifications of the motor vehicle 1 (e.g., the specifications in which a DC-DC converter is mounted in advance) by removing the first accommodation part 40 including the DC-DC converter circuit unit 31 from the second accommodation part 50.

Conversely, there may be a case where, depending on the specifications of the motor vehicle 1, a function of a DC-DC converter is required to be added to the power converter 10 including only the second accommodation part 50 provided with the inverter circuit unit 21. Even in this case, the power converter 10 according to the present embodiment can easily cope with the requirement by merely combining the first accommodation part 40 including the DC-DC converter circuit unit 31 with the second accommodation part 50.

In the second accommodation part 50 of the modified example, a third cover 100 is attached to the third opening portion 513 (not visible in Fig. 10). Unlike the shape of the first cover 42, the third cover 100 is identical in shape with the upper surface 40A of the removed first accommodation part 40. More precisely, the size of the third cover 100 and the attachment positions of fixing members (e.g., bolts) in the third cover 100 are set to become identical or substantially identical with those of the upper surface 40A of the first accommodation part 40.

Thus, in the second accommodation part 50, the third opening portion 513 can be closed by the third cover 100 even when the first accommodation part 40 is removed. It is therefore possible to prevent dust or water from entering the internal space of the second accommodation part 50 through the third opening portion 513.

Since the third cover 100 is identical in shape with the upper surface 40A of the first accommodation part 40 as set forth above, fixing members for attaching the third cover 100 to the second accommodation part 50 and fixing members for fixing the first accommodation part 40 to the second accommodation part 50 can be used in common.

Other effects and other modified examples can be readily derived by those skilled in the relevant art. For that reason, the broad aspect of the present disclosure is not limited to the specific disclosure and the representative embodiment shown and described above. Accordingly, the present disclosure can be modified in many different forms without departing from the spirit and scope thereof defined by the appended claims and the equivalents thereof.

## Claims

1. A power converter, comprising:
a DC-DC converter circuit unit configured to step up or step down a voltage of direct current power supplied from a power supply;
an inverter circuit unit configured to convert direct current power supplied from the power supply to alternating current power; and
a first flow path portion and a second flow path portion through which a cooling medium flows,
wherein the first flow path portion is disposed between the DC-DC converter circuit unit and the inverter circuit unit, and
wherein the second flow path portion is disposed at an opposite side of the inverter circuit unit from a side at which the first flow path portion is disposed.

2. The power converter of claim 1, further comprising:
a control unit configured to control at least one of the inverter circuit unit and the DC-DC converter circuit unit, the control unit being disposed at an opposite side of the second flow path portion from a side at which the inverter circuit unit is disposed.

3. The power converter of claim 1 or 2, further comprising:
a first accommodation part which accommodates the DC-DC converter circuit unit, the first flow path portion being formed in the first accommodation part; and
a second accommodation part which is coupled to the first accommodation part and accommodates the inverter circuit unit, the second flow path portion being formed in the second accommodation part.

4. The power converter of claim 3, wherein the first accommodation part is separable from the second accommodation part.

5. The power converter of claim 3 or 4, wherein the first accommodation part includes a first coupling surface coupled to the second accommodation part and a first opening portion formed on a surface opposite to the first coupling surface, and
wherein the second accommodation part includes a second coupling surface coupled to the first accommodation part and a second opening portion formed on a surface opposite to the second coupling surface.

6. The power converter of any one of claims 3 to 5, wherein the first accommodation part includes at least one communication hole through which a wiring line extending between the second accommodation part and the first accommodation part passes.

7. The power converter of claim 6, wherein the at least one communication hole includes two or more communication holes.

8. The power converter of any one of claims 3 to 7, wherein the first accommodation part includes three or more cooling medium outlet/inlet portions, two of the outlet/inlet portions being connected to each other through the first flow path portion.

9. The power converter of any one of claims 3 to 8, wherein at least one of the first accommodation part and the second accommodation part includes an attachment portion for attaching the power converter to a target attachment region.

10. The power converter of any one of claims 1 to 9, wherein the DC-DC converter circuit unit and the first flow path portion are disposed in contact with each other, and
wherein the inverter circuit unit and the second flow path portion are disposed in contact with each other.

11. The power converter of any one of claims 1 to 10, wherein the DC-DC converter circuit unit, the first flow path portion, the inverter circuit unit, and the second flow path portion are stacked one above another in that order.

12. A motor vehicle comprising the power converter of any one of claims 1 to 11.
